(19) Europäisches Patentamt / European Patent Office / Office européen des brevets

(11) **EP 2 775 555 B1**

(12) # EUROPEAN PATENT SPECIFICATION

(45) Date of publication and mention of the grant of the patent:
**26.10.2016 Bulletin 2016/43**

(21) Application number: **12846081.3**

(22) Date of filing: **04.09.2012**

(51) Int Cl.:
***G01R 31/36*** *(2006.01)*
***H01M 4/133*** *(2010.01)*
***H01M 4/36*** *(2006.01)*
***H01M 10/0525*** *(2010.01)*
***H01M 10/0568*** *(2010.01)*
*H01M 10/04 (2006.01)*
*H01M 10/0567 (2010.01)*

(86) International application number:
**PCT/JP2012/005599**

(87) International publication number:
**WO 2013/065223 (10.05.2013 Gazette 2013/19)**

(54) **EVALUATION METHOD FOR A NON-AQUEOUS ELECTROLYTE SECONDARY BATTERY**

BEURTEILUNGSVERFAHREN FÜR EINE SEKUNDÄRBATTERIE MIT WASSERFREIEM ELEKTROLYT

PROCÉDÉ D'ÉVALUATION POUR UNE BATTERIE SECONDAIRE À ÉLECTROLYTE NON-AQUEUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.10.2011 JP 2011238845**

(43) Date of publication of application:
**10.09.2014 Bulletin 2014/37**

(73) Proprietor: **Toyota Jidosha Kabushiki Kaisha**
**Toyota-shi, Aichi 471-8571 (JP)**

(72) Inventors:
- **NAKANO, Tomohiro**
  **Toyota-shi,**
  **Aichi 471-8571 (JP)**
- **ONIZUKA, Hiroshi**
  **Toyota-shi,**
  **Aichi 471-8571 (JP)**
- **KIKUCHI, Kyoko**
  **Toyota-shi,**
  **Aichi 471-8571 (JP)**
- **SAKANO, Mitsuru**
  **Toyota-shi,**
  **Aichi 471-8571 (JP)**

(74) Representative: **TBK**
**Bavariaring 4-6**
**80336 München (DE)**

(56) References cited:
**WO-A1-2011/016113**
**JP-A- 2007 180 015**
**JP-A- 2008 016 414**
**JP-A- 2010 238 506**
**US-A1- 2011 104 564**

- **KANG XU ET AL: "Graphite/Electrolyte Interface Formed in LiBOB-Based Electrolytes", JOURNAL OF THE ELECTROCHEMICAL SOCIETY, vol. 151, no. 12, 1 January 2004 (2004-01-01), page A2106, XP055167733, ISSN: 0013-4651, DOI: 10.1149/1.1812732**
- **OTA H ET AL: "XAFS and TOF-SIMS analysis of SEI layers on electrodes", JOURNAL OF POWER SOURCES, ELSEVIER SA, CH, vol. 119-121, 1 June 2003 (2003-06-01), pages 567-571, XP004430232, ISSN: 0378-7753, DOI: 10.1016/S0378-7753(03)00291-X**
- **CHIHIRO YOGI ET AL: "Soft X-ray absorption spectroscopic studies with different probing depths: Effect of an electrolyte additive on electrode surfaces", JOURNAL OF POWER SOURCES, vol. 248, 18 October 2013 (2013-10-18), pages 994-999, XP055167739, ISSN: 0378-7753, DOI: 10.1016/j.jpowsour.2013.10.030**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Technical Field

The present invention relates to
a method of evaluating a non-aqueous electrolyte secondary battery.

### Background Art

A lithium secondary battery is an example of non-aqueous electrolyte secondary batteries. The lithium secondary battery is a secondary battery capable of charging and discharging electricity by allowing lithium ions in a non-aqueous electrolyte solution to move between a positive electrode and a negative electrode that absorb and emit lithium ions.

Patent Literature 1 discloses a technique related to a non-aqueous electrolyte secondary battery having excellent battery characteristics such as storage characteristics and output characteristics. The non-aqueous electrolyte secondary battery disclosed in Patent Literature 1 includes a positive electrode including a positive-electrode active material, a negative electrode including a negative-electrode active material, and a non-aqueous electrolyte solution. The non-aqueous electrolyte solution contains lithium salt having an oxalate complex as an anion, and acetonitrile. The content of acetonitrile is 0.6 mass% to 1.0 mass% with respect to the content of lithium salt having an oxalate complex as an anion.

Xu K. et al.: "Graphite/Electrolyte Interface Formed in LiBOB-Based Electrolytes", Journal of the Electrochemical Society, vol. 151, no. 12, 1 January 2004, pages A2106 to A2112, XP055167733, ISSN: 0013-4651, DOI: 10.1149/1.1812732 discloses a dynamic picture of solid electrolyte interface formation on a graphitic anode surface during the initial forming cycle.

Ota H. et al.: "XAFS and TOF-SIMS analysis of SEI layers on electrodes", Journal of Power Sources, Elsevier Sa, CH, vol. 119-121, 1 June 2003, pages 567-571, XP004430232, ISSN: 0378-7753, DOI: 10.1016/S0378-7753(03)00291-X describes the analysis of the solid electrolyte interface layer on the graphite anode and the $LiCoO_2$ cathode in a lithium-ion battery using X-ray absorption fine structure.

US2011104564 (A1) describes a method for manufacturing a lithium secondary battery, characterized by having: a processing lithium secondary battery preparing step for preparing a processing lithium secondary battery that has a positive electrode layer containing $LiFePO_4$ as a positive-electrode active material, a negative electrode layer containing a carbon material as a negative-electrode active material, and nonaqueous electrolyte solution containing $LiPF_6$ and LiBOB; and a film forming step of performing a charging process on the processing lithium secondary battery until a voltage of the processing lithium secondary battery falls within a high voltage range in which a film of an oxidative decomposition product of a BOB anion contained in the LiBOB is formed on a surface of the positive-electrode active material.

### Citation List

### Patent Literature

[Patent Literature 1] Japanese Unexamined Patent Application Publication No. 2011-34893

### Summary of Invention

### Technical Problem

Non-aqueous electrolyte secondary batteries have a problem that when the batteries are used in a high-temperature environment, for example, the battery characteristics deteriorate depending on the environment in which the batteries are used. In other words, non-aqueous electrolyte secondary batteries have a problem that the capacity retention ratio of the batteries is lowered, or the internal resistance of each electrode is increased, under the influence of the environment in which the batteries are used.

In order to solve the above-mentioned problems, according to Patent Literature 1, lithium bis(oxalate)borate (LiBOB) is added to a non-aqueous electrolyte solution, and a coating derived from LiBOB is formed on a negative electrode. Also, Patent Literature 1 defines the additive amount of LiBOB to be added to the non-aqueous electrolyte solution. However, the state of the coating derived from LiBOB formed on the negative electrode changes depending on the conditions for generating the coating. Accordingly, even when the additive amount of LiBOB is defined, the effect due to the formation of the coating changes depending on the state of the coating to be formed.

In view of the above-mentioned problems, it is an object of the present invention to provide
**a** method of evaluating **a** non-aqueous electrolyte secondary battery.

**Solution to Problem**

The present invention provides a method as defined in claim 1. Further beneficial embodiments are defined in dependent claims 2 to 5. A non-aqueous electrolyte secondary battery includes a positive electrode, a negative electrode, and a non-aqueous electrolyte solution. The negative electrode includes a coating derived from lithium bis(oxalate)borate, and assuming that an intensity of a peak attributable to a three-coordinate structure of the coating measured by an XAFS method is represented by $\alpha$ and an intensity of a peak attributable to a four-coordinate structure of the coating measured by the XAFS method is represented by $\beta$, the coating satisfies a condition of $\alpha/(\alpha+\beta) \geq 0.4$.

In the non-aqueous electrolyte secondary battery, the coating may satisfy a condition of $\alpha/(\alpha+\beta) \geq 0.49$.

In the non-aqueous electrolyte secondary battery, the coating may satisfy a condition of $\alpha/(\alpha+\beta) \geq 0.7$.

In the non-aqueous electrolyte secondary battery, the coating may satisfy a condition of $\alpha/(\alpha+\beta) \geq 0.79$.

In the measurement by the XAFS method, the three-coordinate structure of the coating may be detected by using a peak of X-ray energy in the vicinity of 194 eV, and the four-coordinate structure of the coating may be detected by using a peak of X-ray energy in the vicinity of 198 eV.

A method of manufacturing a non-aqueous electrolyte secondary battery is a method of manufacturing a non-aqueous electrolyte secondary battery including a positive electrode, a negative electrode, and a non-aqueous electrolyte solution, the method including: adding lithium bis(oxalate)borate to the non-aqueous electrolyte solution with a concentration of lithium bis(oxalate)borate of less than 0.05 mol/kg in the non-aqueous electrolyte solution; and performing a conditioning process that performs charging and discharging processes on the non-aqueous electrolyte secondary battery a predetermined number of times.

In the method of manufacturing the non-aqueous electrolyte secondary battery, lithium bis(oxalate)borate may be added to the non-aqueous electrolyte solution with a concentration of lithium bis(oxalate)borate of less than 0.04 mol/kg in the non-aqueous electrolyte solution.

In the method of manufacturing the non-aqueous electrolyte secondary battery, lithium bis(oxalate)borate may be added to the non-aqueous electrolyte solution with a concentration of lithium bis(oxalate)borate of 0.025 mol/kg or less in the non-aqueous electrolyte solution.

In the method of manufacturing the non-aqueous electrolyte secondary battery, lithium bis(oxalate)borate may be added to the non-aqueous electrolyte solution with a concentration of lithium bis(oxalate)borate of 0.01 mol/kg or less in the non-aqueous electrolyte solution.

In the method of manufacturing the non-aqueous electrolyte secondary battery, a charge rate and a discharge rate in the conditioning process may each be set to 1.0 C or less.

In the method of manufacturing the non-aqueous electrolyte secondary battery, a charge rate and a discharge rate in the conditioning process may each be set to be equal to or more than 0.1 C and equal to or less than 1.0 C.

In the method of manufacturing the non-aqueous electrolyte secondary battery, the number of times of each of the charging and discharging processes in the conditioning process may be three.

In the method of manufacturing the non-aqueous electrolyte secondary battery, when the conditioning process is performed to form a coating derived from lithium bis(oxalate)borate on the negative electrode, assuming that an intensity of a peak attributable to a three-coordinate structure of the coating measured by an XAFS method is represented by $\alpha$ and an intensity of a peak attributable to a four-coordinate structure of the coating measured by the XAFS method is represented by $\beta$, the coating may be formed so as to satisfy a condition of $\alpha/(\alpha+\beta) \geq 0.4$.

A method of evaluating a non-aqueous electrolyte secondary battery according to the present invention is a method of evaluating a non-aqueous electrolyte secondary battery including a positive electrode, a negative electrode, and a non-aqueous electrolyte solution, the method including: measuring, by an XAFS method, an intensity $\alpha$ of a peak attributable to a three-coordinate structure of a coating derived from lithium bis(oxalate)borate formed on the negative electrode; measuring, by the XAFS method, an intensity $\beta$ of a peak attributable to a four-coordinate structure of the coating; and evaluating the non-aqueous electrolyte secondary battery based on whether or not the coating satisfies $\alpha/(\alpha+\beta) \geq 0.4$.

In the method of evaluating the non-aqueous electrolyte secondary battery according to the present invention, the non-aqueous electrolyte secondary battery may be evaluated based on whether or not the coating satisfies $\alpha/(\alpha+\beta) \geq 0.49$.

In the method of evaluating the non-aqueous electrolyte secondary battery according to the present invention, the non-aqueous electrolyte secondary battery may be evaluated based on whether or not the coating satisfies $\alpha/(\alpha+\beta) \geq 0.7$.

In the method of evaluating the non-aqueous electrolyte secondary battery according to the present invention,

the non-aqueous electrolyte secondary battery may be evaluated based on whether or not the coating satisfies $\alpha/(\alpha+\beta) \geq 0.79$.

In the method of evaluating the non-aqueous electrolyte secondary battery according to the present invention, the three-coordinate structure of the coating is detected by using a peak of X-ray energy in the vicinity of 194 eV, and the four-coordinate structure of the coating is detected by using a peak of X-ray energy in the vicinity of 198 eV.

## Advantageous Effects of Invention

According to the present invention, it is possible to provide a method of evaluating a non-aqueous electrolyte secondary battery.

## Brief Description of Drawings

Fig. 1 is a graph showing a relationship between a LiBOB concentration of a non-aqueous electrolyte solution and battery characteristics of a lithium secondary battery;
Fig. 2 shows results of measuring, by an XAFS method, a negative electrode surface of a lithium secondary battery on which a conditioning process is not performed and measuring a negative electrode surface of a lithium secondary battery on which a conditioning process is performed;
Fig. 3 shows results of measuring, by the XAFS method, the negative electrode surface of the lithium secondary battery (when the LiBOB concentration of the non-aqueous electrolyte solution is changed);
Fig. 4 shows a relationship between a LiBOB concentration in a non-aqueous electrolyte solution and a three-coordinate structure ratio X, as a result of measuring, by the XAFS method, the negative electrode surface of the lithium secondary battery;
Fig. 5 is a table showing relationships among a three-coordinate structure ratio, a resistance increase ratio, and a capacity retention ratio when the LiBOB concentration in the non-aqueous electrolyte solution is changed;
Fig. 6 is a table showing relationships among a three-coordinate structure ratio, a resistance increase ratio, and a capacity retention ratio when the condition (charge/discharge rate) for the conditioning process is changed; and
Fig. 7 is a table showing relationships among a three-coordinate structure ratio, a resistance increase ratio, and a capacity retention ratio when the condition (the number of cycles) for the conditioning process is changed.

## Description of Embodiments

A non-aqueous electrolyte secondary battery (hereinafter referred to as a lithium secondary battery) according to an embodiment includes at least a positive electrode, a negative electrode, and a non-aqueous electrolyte solution.

<Positive electrode>

The positive electrode includes a positive-electrode active material. The positive-electrode active material is a material capable of absorbing and emitting lithium. For example, lithium cobalt oxide ($LiCoO_2$), lithium manganese oxide ($LiMn_2O_4$), lithium nickel oxide ($LiNiO_2$), or the like can be used. A material obtained by mixing $LiCoO_2$, $LiMn_2O_4$, and $LiNiO_2$ at a given ratio can also be used. For example, $LiNi_{1/3}Co_{1/3}Mn_{1/3}O_2$ which is obtained by mixing these materials at the same ratio can be used.

The positive electrode may include an electrically conductive material. As the electrically conductive material, for example, acetylene black (AB), carbon black such as Ketjenblack, or graphite can be used.

The positive electrode of the lithium secondary battery according to this embodiment can be prepared by, for example, kneading a positive-electrode active material, an electrically conductive material, a solvent, and a binder, applying a positive electrode mixture, which is obtained after kneading, to a positive electrode collector, and drying the mixture. As the solvent, for example, an NMP (N-methyl-2-pyrrolidone) solution can be used. As the binder, for example, polyvinylidene difluoride (PVdF), styrene-butadiene rubber (SBR), polytetrafluoroethylene (PTFE), carboxymethyl cellulose (CMC), or the like can be used. As the positive electrode collector, aluminum or an alloy containing aluminum as a main component can be used.

<Negative electrode>

A negative-electrode active material is a material capable of absorbing and emitting lithium. For example, a powder carbon material including graphite or the like can be used. Similarly to the positive electrode, the negative

electrode can be prepared by kneading a negative-electrode active material, a solvent, and a binder, applying a negative electrode mixture, which is obtained after kneading, to a negative electrode collector, and drying the resultant. As the negative electrode collector, for example, copper, nickel, or an alloy of these materials can be used.

<Non-aqueous electrolyte solution>

The non-aqueous electrolyte solution is a composition containing a supporting electrolyte in a non-aqueous solvent. As the non-aqueous solvent, one type or two or more types of materials selected from the group consisting of propylene carbonate (PC), ethylene carbonate (EC), diethyl carbonate (DEC), dimethyl carbonate (DMC), ethyl methyl carbonate (EMC), and the like can be used. As the supporting electrolyte, one type or two or more types of lithium compounds (lithium salt) selected from the group consisting of $LiPF_6$, $LiBF_4$, $LiClO_4$, $LiAsF_6$, $LiCF_3SO_3$, $LiC_4F_9SO_3$, $LiN(CF_3SO_2))_2$, $LiC(CF_3SO_2)_3$, LiI, and the like can be used.

In the lithium secondary battery according to this embodiment, lithium bis(oxalate)borate (LiBOB) is added to the non-aqueous electrolyte solution. For example, LiBOB is added to the non-aqueous electrolyte solution with a LiBOB concentration of less than 0.05 mol/kg in the non-aqueous electrolyte solution. The addition of LiBOB to the non-aqueous electrolyte solution in this manner makes it possible to improve the battery characteristics of the lithium secondary battery. At this time, LiBOB may be added to the non-aqueous electrolyte solution with a LiBOB concentration of 0.04 mol/kg or less, preferably, 0.025 mol/kg or less, and more preferably, 0.01 mol/kg or less, in the non-aqueous electrolyte solution.

<Separator>

The lithium secondary battery according to this embodiment may include a separator. As the separator, a porous polymer film such as a porous polyethylene film, a porous polyolefin film, or a porous polyvinyl chloride film, or a lithium ion or ionic conductive polymer electrolyte film can be used singly or in combination.

<Lithium secondary battery>

Hereinafter, a lithium secondary battery including a wound electrode body will be described as an example. In the lithium secondary battery according to this embodiment, an electrode body (wound electrode body) having a form in which an elongated positive electrode sheet (positive electrode) and an elongated negative electrode sheet (negative electrode) are wound in a flat shape with an elongated separator interposed therebetween is housed with a non-aqueous electrolyte solution in a container having a shape that can house the wound electrode body.

The container includes a flat rectangular parallelepiped container body with an open upper end, and a lid body that seals the opening. As a material for forming the container, a metallic material such as aluminum or steel is preferably used. Alternatively, a container obtained by molding a resin material such as polyphenylene sulfide resin (PPS) or polyimid resin can also be used. The upper surface (that is, the lid body) of the container is provided with a positive electrode terminal electrically connected to a positive electrode of the wound electrode body and a negative electrode terminal electrically connected to a negative electrode of the wound electrode body. The container houses the flat wound electrode body together with the non-aqueous electrolyte solution.

The positive electrode sheet has a structure in which positive electrode mixture layers including a positive-electrode active material are held on both surfaces of a foil-like positive electrode collector. Similarly to the positive electrode sheet, the negative electrode sheet has a structure in which negative electrode mixture layers including a negative-electrode active material are held on both surfaces of a foil-like negative electrode collector. In the case of preparing the wound electrode body, the positive electrode sheet and the negative electrode sheet are stacked with the separator interposed therebetween. The stacked structure obtained by stacking the sheets is wound, and the wound body thus obtained is pressed, thereby preparing the flat wound electrode body.

A positive electrode lead terminal and a negative electrode lead terminal are respectively provided to the portions at both ends of the wound electrode body where the positive electrode sheet and the negative electrode sheet are respectively exposed (the portions where the positive electrode mixture layer and the negative electrode mixture layer are not formed), and the positive electrode terminal and the negative electrode terminal are electrically connected to the positive electrode lead terminal and the negative electrode lead terminal, respectively. In this manner, the wound electrode body thus prepared is housed in the container body, and the non-aqueous electrolyte solution is poured into the container body. Then the opening of the container body is sealed with the lid body. In this manner, the lithium secondary battery according to this embodiment can be prepared.

<Conditioning process>

A conditioning process is performed on the lithium secondary battery prepared by the method described above. The conditioning process can be performed by repeating charging and discharging of the lithium secondary battery a predetermined number of times. For example, the conditioning process can be performed by the operation of charging the lithium secondary battery at a constant current and a constant voltage to 4.1 V at a charge rate of 0.1 C and the operation of discharging the lithium secondary battery at a constant current and a constant voltage to 3.0 V at a discharge rate of 0.1 C in a temperature condition of 20°C each being repeated three times. Note that the conditioning process is not limited to these conditions, and the charge rate, the discharge rate, the set voltage for charging/discharging can be arbitrarily set. In the lithium secondary battery according to this embodiment, the execution of the conditioning process makes it possible to form a coating derived from lithium bis(oxalate)borate (LiBOB) on a negative electrode surface. This coating is formed in such a manner that LiBOB added to the non-aqueous electrolyte solution is deposited on the negative electrode surface when the conditioning process is performed.

<Method of evaluating the negative electrode according to one embodiment of the present invention>

The negative electrode of the lithium secondary battery obtained after the conditioning process can be evaluated by performing a measurement by an XAFS (X-ray Absorption Fine Structure) method. Specifically, as coatings derived from LiBOB formed on the negative electrode surface, a coating (a coating having a three-coordinate structure) with a boron coordination number of 3 and a coating (a coating having a four-coordinate structure) with a boron coordination number of 4 are mixed with each other. In this embodiment, the ratio of the coating having the three-coordinate structure to the coating having the four-coordinate structure can be obtained by using the XAFS method.

In the measurement by the XAFS method, soft X-rays having a low energy are used to analyze boron on the uppermost surface of the negative electrode. A peak in the vicinity of 194 eV is used to detect the three-coordinate structure (that is, three-coordinate boron), and a peak in the vicinity of 198 eV is used to detect the four-coordinate structure (that is, four-coordinate boron). The ratio $X=\alpha/(\alpha+\beta)$ of the three-coordinate structure is obtained based on a peak intensity $\alpha$ of the three-coordinate structure and a peak intensity $\beta$ of the four-coordinate structure.

Assume that in the lithium secondary battery according to this embodiment, the ratio of the coating having the three-coordinate structure derived from LiBOB formed on the negative electrode surface satisfies $X \geq 0.4$. Thus, by setting the ratio of the coating having the three-coordinate structure to satisfy $X \geq 0.4$, the battery characteristics of the lithium secondary battery can be improved. Further, the ratio of the coating having the three-coordinate structure is set to satisfy $X \geq 0.49$, preferably $X \geq 0.7$, and more preferably $X \geq 0.79$, thereby making it possible to further improve the battery characteristics of the lithium secondary battery. Note that in the lithium secondary battery according to this embodiment, the battery characteristics of the lithium secondary battery are most improved when the ratio of the coating having the three-coordinate structure is expressed as $X=1$.

To form the coating as described above, the LiBOB concentration in the non-aqueous electrolyte solution is set to be less than 0.05 mol/kg. For example, to set the ratio of the coating having the three-coordinate structure to satisfy $X \geq 0.4$, the LiBOB concentration in the non-aqueous electrolyte solution is set to 0.04 mol/kg or less. To set the ratio of the coating having the three-coordinate structure to satisfy $X \geq 0.49$, the LiBOB concentration in the non-aqueous electrolyte solution is set to 0.025 mol/kg or less. To set the ratio of the coating having the three-coordinate structure to satisfy $X \geq 0.7$, the LiBOB concentration in the non-aqueous electrolyte solution is set to 0.01 mol/kg or less.

In this embodiment, the non-aqueous electrolyte secondary battery can be evaluated based on whether or not the coating derived from LiBOB formed on the negative electrode surface satisfies $\alpha/(\alpha+\beta) \geq 0.4$. In other words, when the coating formed on the negative electrode surface satisfies the condition of $\alpha/(\alpha+\beta) \geq 0.4$, it can be determined that the lithium secondary battery has excellent battery characteristics.

Lithium secondary batteries have a problem that the battery characteristics deteriorate depending on the environment in which the batteries are used, for example, when the batteries are used in a high-temperature environment. In other words, lithium secondary batteries have a problem that the capacity retention ratio of the batteries is lowered, or the internal resistance of each electrode is increased, under the influence of the environment in which the batteries are used.

To solve such a problem, according to Patent Literature 1, lithium bis(oxalate)borate (LiBOB) is added to a non-aqueous electrolyte solution, and a coating derived from LiBOB is formed on a negative electrode. Also, Patent Literature 1 defines the additive amount of LiBOB to be added to the non-aqueous electrolyte solution. However, the state of the coating derived from LiBOB formed on the negative electrode changes depending on the conditions for generating the coating, for example. Accordingly, even when the additive amount of LiBOB is defined, the effect due to the formation of the coating changes depending on the state of the coating to be formed. Therefore, it is apprehended that even when LiBOB is added to the non-aqueous electrolyte solution, the effect of improving the battery characteristics due to the formation of the coating is not obtained.

Specifically, lithium bis(oxalate)borate ($LiB(C_2O_4)_2$), which has a four-coordinate structure with boron having oxalate complexes, may be decomposed into deterioration products having a four-coordinate structure, such as $LiF_2OB$ (=$LiF_2B(C_2O_4)$) and $LiBF_4$, or may generate $(COOH)_2$, by a reaction to be described later. The presence of deterioration products is confirmed by an NMR measurement. These deterioration products ($LiF_2OB$, $LiBF_4$) and $(COOH)_2$ may cause deterioration in the capacity retention ratio of lithium secondary batteries, or an increase in the internal resistance of each electrode of lithium secondary batteries, which may cause deterioration in the battery characteristics thereof. Therefore, it is apprehended that even when LiBOB is added to the non-aqueous electrolyte solution, the effect of improving the battery characteristics due to the formation of the coating is not obtained.

[Formula 1]

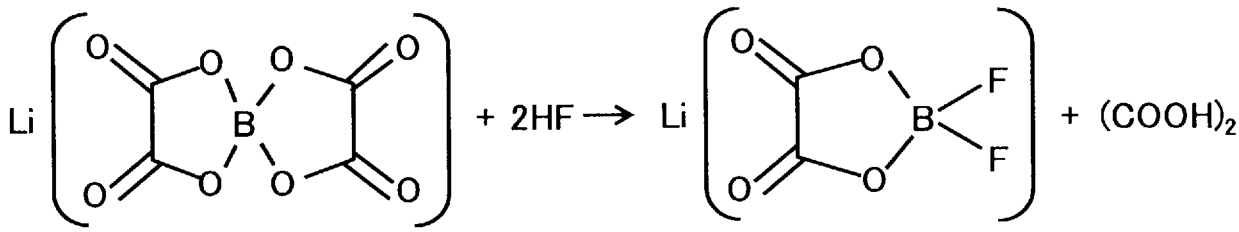

LiBOB (=$LiB(C_2O_4)_2$) $LiF_2B(C_2O_4)$

[Formula 2]

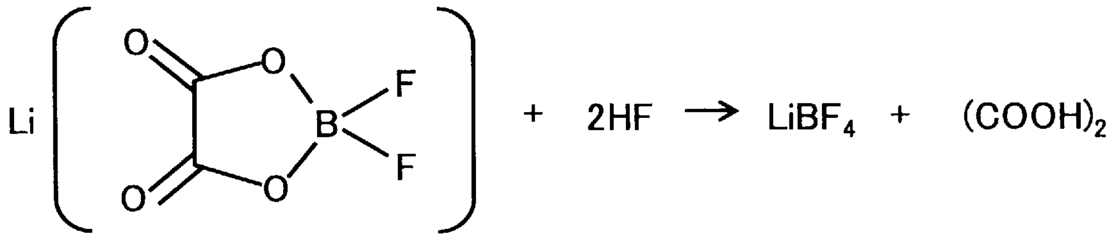

[Formula 3]

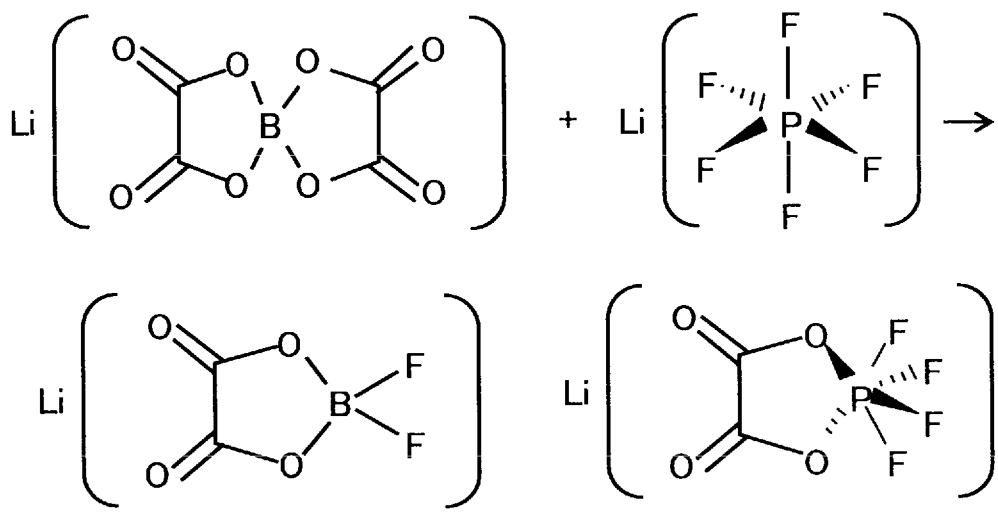

$LiF_2B(C_2O_4)$

In the lithium secondary battery according to this embodiment, LiBOB is added to the non-aqueous electrolyte

solution, and the ratio of the coating having the three-coordinate structure derived from LiBOB formed on the negative electrode surface is set to satisfy $X \geq 0.4$, thereby improving the battery characteristics. Specifically, it can be surmised that when the negative electrode surface is coated by the coating having the three-coordinate structure derived from LiBOB, a reaction field involved in, for example, the absorption and emission of Li ions, can be increased or the activation energy necessary for the reaction can be reduced (in other words, the reaction can be promoted). A surmised structural formula of the coating having the three-coordinate structure derived from LiBOB formed on the negative electrode surface is given below. Note that in this embodiment, the structural formula of the coating having the three-coordinate structure is not limited to the structural formula given below, and any structure may be employed, as long as the coating has a three-coordinate structure with a boron coordination number of 3.

[Formula 4]

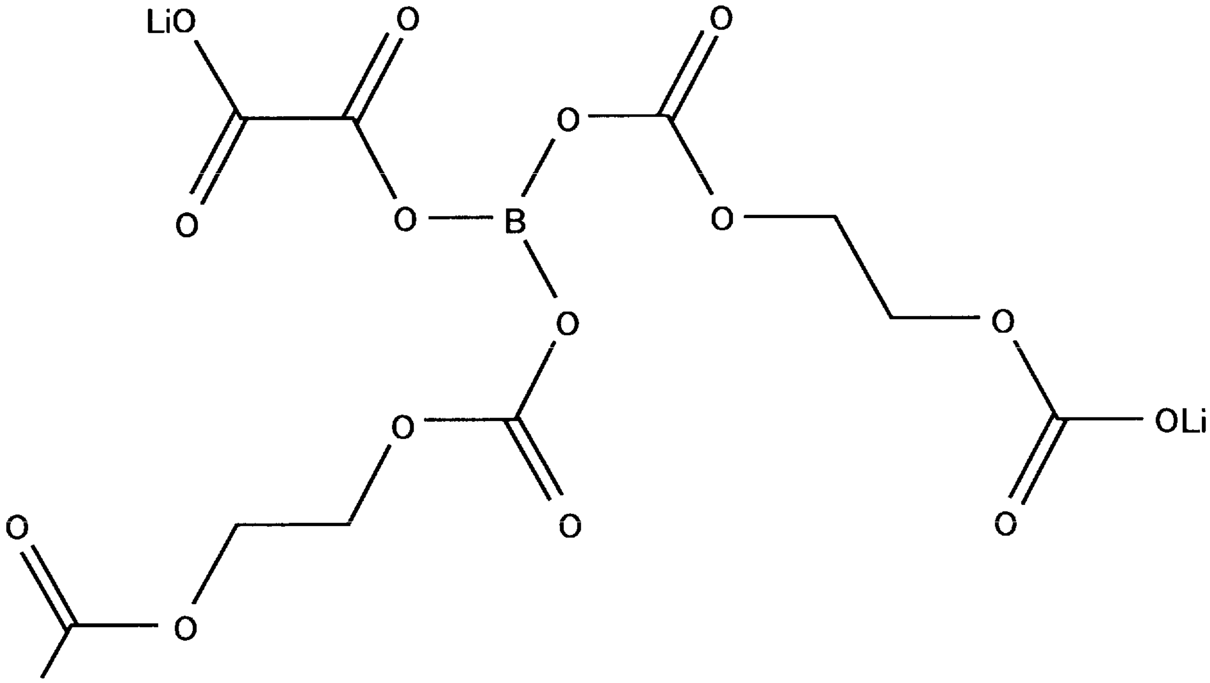

The coating having the three-coordinate structure derived from LiBOB is not formed by just immersing the negative electrode in the non-aqueous electrolyte solution. In order to form the coating having the three-coordinate structure on the negative electrode surface, it is necessary to perform the conditioning process in a predetermined condition. For example, the coating having the three-coordinate structure can be formed on the negative electrode surface by applying a potential of more than 1.7 V (vs $Li/Li^+$).

Further, whether or not the coating having the three-coordinate structure and the coating having the four-coordinate structure, which are derived from LiBOB, are present on the negative electrode surface can be verified by the following method. (1) First, it is confirmed whether a boron atom is present or not, by using an ICP (Inductively Coupled Plasma) emission spectrometry analysis method. (2) Next, it is confirmed whether $(COOH)_2$ is present or not, by using an ion chromatograph. (3) Lastly, it is confirmed whether a peak (in the vicinity of 194 eV) of three-coordinate boron and a peak (in the vicinity of 198 eV) of four-coordinate boron are present or not, by using the XAFS method.

When the presence of a boron atom is confirmed by the ICP emission spectrometry analysis method and the presence of $(COOH)_2$ is confirmed by the ion chromatograph, and when a peak of there-coordinate boron and a peak of four-coordinate boron are confirmed by the XAFS method, it can be said that the coating having the three-coordinate structure and the coating having the four-coordinate structure, which are derived from LiBOB, are present. As described above, $(COOH)_2$ is generated when LiBOB is decomposed into four-coordinate deterioration products. Accordingly, whether LiBOB is present or not can be determined based on the presence or absence of $(COOH)_2$.

The invention according to the embodiments of the method described above can provide a method of evaluating a non-aqueous electrolyte secondary battery.

[Examples]

Next, examples of the present invention will be described.

<Preparation of the positive electrode>

The mass ratio of materials including $LiNi_{1/3}Co_{1/3}Mn_{1/3}O_2$ as a positive-electrode active material, acetylene black (AB) as an electrically conductive material, and PVDF as a binder was adjusted to 90:8:2. These adjusted materials were mixed and kneaded with an NMP (N-methyl-2-pyrrolidone) solution. The positive electrode mixture obtained after kneading was applied, in a band shape, to both surfaces of an elongated aluminum foil (positive electrode collector) with a thickness of 15 $\mu$m and was dried, thereby preparing a positive electrode sheet having a structure in which positive electrode mixture layers are formed on both of the surfaces of the positive electrode collector. The total amount of the positive electrode mixture applied to both of these surfaces was adjusted to about 11.8 mg/cm$^2$ (solid content standards). After drying, the resultant was pressed to a positive electrode mixture layer density of about 2.3 g/cm$^3$.

<Preparation of the negative electrode>

A negative electrode mixture was prepared by dispersing materials including natural graphite powder as a negative-electrode active material, SBR, and CMC into water at a mass ratio of 98.6:0.7:0.7. This negative electrode mixture was applied to both surfaces of an elongated copper foil (negative electrode collector) with a thickness of 10 $\mu$m and was dried, thereby preparing a negative electrode sheet having a structure in which negative electrode mixture layers are formed on both of the surfaces of the negative electrode collector. The total amount of the negative electrode mixture applied to both of these surfaces was adjusted to about 7.5 mg/cm$^2$ (solid content standards). After drying, the resultant was pressed to a negative electrode mixture layer density of about 1.0 g/cm$^3$ to 1.4 g/cm$^3$.

<Lithium secondary battery>

The positive electrode sheet and the negative electrode sheet, which were prepared as described above, were stacked with two separators (separators which are made of porous polyethylene and have a monolayer structure were used) interposed therebetween and were wound, and the wound body was pressed in a lateral direction, thereby preparing a flat wound electrode body. This wound electrode body and the non-aqueous electrolyte solution were housed in a box-shaped battery container, and the opening of the battery container was air-tightly sealed.

A solution obtained by adding $LiPF_6$ as a supporting electrolyte with a concentration of about 1 mol/kg to a mixed solvent including EC, EMC, and DMC at a volume ratio of 3:3:4 was used as the non-aqueous electrolyte solution. Further, LiBOB was added with a LiBOB concentration in the non-aqueous electrolyte solution of 0 to 0.1 mol/kg. In this manner, the lithium secondary battery was assembled. After that, in a temperature condition of 20°C, the conditioning process was performed by the operation of charging the lithium secondary battery at a constant current and a constant voltage to 4.1 V at a charge rate of 0.1 C and the operation of discharging the lithium secondary battery at a constant current and a constant voltage to 3.0 V at a discharge rate of 0.1 C each being repeated three times, thereby obtaining the lithium secondary battery for testing.

<Measurement of the low-temperature reaction resistance>

The low-temperature reaction resistance of each lithium secondary battery prepared as described above was measured. The low-temperature reaction resistance was measured in the following manner. First, the state of charge of each lithium secondary battery obtained after the conditioning process was adjusted to an SOC (State of Charge) of 60%. After that, in a temperature condition of -30°C, the reaction resistance was measured by an alternating-current impedance method at a frequency ranging from 10 mHz to 1 MHz. The measurement of the low-temperature reaction resistance was performed on the lithium secondary battery having a LiBOB concentration in the non-aqueous electrolyte solution of 0 to 0.1 mol/kg.

<Measurement of the capacity retention ratio>

A retention endurance test was conducted on each lithium secondary battery prepared as described above, and the capacity retention ratio thereof was measured. The retention endurance test was conducted in such a manner that the state of charge of the lithium secondary battery obtained after the conditioning process was adjusted to an SOC of 80% and the lithium secondary battery was then left for a month in an environment of 60°C. Further, the capacity retention ratio was measured in the following manner.

The capacity retention ratio was obtained by using the following formula, assuming that the discharge capacity obtained before the retention endurance test is a discharge capacity A and the discharge capacity obtained after the retention endurance test is a discharge capacity B.

$$\text{capacity retention ratio } (\%) = (\text{discharge capacity B}/\text{discharge capacity A}) \times 100$$

Note that the discharge capacity A and the discharge capacity B were calculated as follows. First, in a temperature environment of 20°C, each lithium secondary battery was discharged at a constant current with a current density of 0.2 mA/cm$^2$ so that the battery voltage changed from an upper limit voltage value of 4.2 V to a lower limit voltage value of 3.0 V. The discharge capacity A and the discharge capacity B were calculated by dividing the discharge electricity quantity (mAh) obtained at that time by the mass (g) of the positive-electrode active material within each lithium secondary battery.

<Relationship between LiBOB concentration and battery characteristics>

Fig. 1 shows a relationship between the LiBOB concentration and the battery characteristics (the capacity retention ratio and the low-temperature reaction resistance) of each lithium secondary battery prepared as described above. As shown in Fig. 1, the low-temperature reaction resistance has a proportional relationship with the LiBOB concentration in the non-aqueous electrolyte solution. In other words, the low-temperature reaction resistance tends to increase as the LiBOB concentration in the non-aqueous electrolyte solution increases. It is surmised that this is because more four-coordinate deterioration products ($LiF_2OB$, $LiBF_4$) or $(COOH)_2$ having a high resistance are deposited as the LiBOB concentration increases.

Also, the capacity retention ratio was highest when the LiBOB concentration in the non-aqueous electrolyte solution was 0.05 mol/kg. That is, the capacity retention ratio decreased as the LiBOB concentration became lower than 0.05 mol/kg, and the capacity retention ratio decreased as the LiBOB concentration became higher than 0.05 mol/kg.

It can be said that the lithium secondary battery having a higher capacity retention ratio and a lower low-temperature reaction resistance shows excellent battery characteristics. Accordingly, from the results shown in Fig. 1, it can be said that the battery characteristics are improved when the LiBOB concentration in the non-aqueous electrolyte solution is less than 0.05 mol/kg.

<Evaluation of the negative electrode surface by the XAFS method>

The negative electrode surface of each lithium secondary battery prepared as described above was measured by the XAFS method to evaluate the ratio of the coating having the three-coordinate structure derived from LiBOB formed on the negative electrode surface. In the XAFS method, an X-ray is made incident on a sample to thereby measure the intensity of the X-ray obtained before the sample is irradiated with the X-ray and the intensity of the X-ray has passed through the sample. In this case, it is necessary to change the energy of the incident X-ray. The measurement by the XAFS method herein described was carried out using BL-12 of the Kyushu Synchrotron Light Research Center which was established by Saga Prefecture. In this measurement, M22 was used as a mirror to measure a B-K end (190 to 210 eV). The M22 has an energy range from 180 to 550 eV. As slit conditions, S1:10 $\mu$m and S2:10 $\mu$m are set.

In the case of measuring an interval from 191 to 210 eV, an integration was performed for one second at energy spacings given below to thereby obtain data. The energy spacing in the range from 191 to 192 eV was 0.5 eV; the energy spacing in the range from 192 to 196 eV was 0.1 eV; the energy spacing in the range from 196 to 203 eV was 0.2 eV; the energy spacing in the range from 203 to 205 eV was 0.5 eV; and the energy spacing in the range from 205 to 210 eV was 1.0 eV. That is, since a peak in the vicinity of 194 eV was used to detect three-coordinate boron and a peak in the vicinity of 198 eV was used to detect four-coordinate boron, the energy spacing in the energy range from 192 eV to 230 eV was set to a relatively small value.

In the measurement, in order to suppress alteration of the sample due to moisture, the work for disassembling the lithium secondary battery was carried out within a glove box having a dew point of -80°C or less. In the case of introducing the sample into the measurement device BL-12, the sample was placed in an atmosphere-closed sample transfer device within the glove box so as to prevent the sample from being exposed to the atmosphere. After that, the sample was introduced into the measurement device BL-12 by using the atmosphere-closed sample transfer device.

For the obtained X-ray absorption spectrum, a base line was created based on data in the range from 191 to 192 eV. After that, the base line was drawn based on peak values of a peak (197 to 199 eV) derived from the four-coordinate structure and a peak (193 to 194 eV) derived from the three-coordinate structure, thereby obtaining each peak intensity. The ratio $X=\alpha/(\alpha+\beta)$ of the three-coordinate structure was obtained using the peak intensity $\alpha$ of the three-coordinate structure and the peak intensity $\beta$ of the four-coordinate structure thus obtained.

First, Fig. 2 shows results of measuring, by the XAFS method, the negative electrode surface of the lithium secondary battery on which the conditioning process was not carried out (that is, the negative electrode was merely immersed in the non-aqueous electrolyte solution) and the negative electrode surface of the lithium secondary battery

on which the conditioning process was carried out. As shown in Fig. 2, in the lithium secondary battery on which the conditioning process was carried out, a peak attributable to the three-coordinate structure appeared on the negative electrode surface. On the other hand, in the lithium secondary battery on which the conditioning process was not carried out, a peak attributable to the three-coordinate structure was not confirmed. Note that a peak attributable to the four-coordinate structure was confirmed regardless of whether or not the conditioning process was carried out. From the results shown in Fig. 2, it turned out that the conditioning process is required to form a coating having a three-coordinate structure on the negative electrode surface.

Next, Fig. 3 shows results of measuring, by the XAFS, the negative electrode surface of each of lithium secondary batteries respectively having LiBOB concentrations in the non-aqueous electrolyte solution of 0.01 mol/kg, 0.025 mol/kg, and 0.05 mol/kg. As shown in Fig. 3, the intensity of a peak attributable to the four-coordinate structure increased as the LiBOB concentration increased.

Further, Fig. 4 shows results of measuring, by the XAFS method, the negative electrode surface of each of lithium secondary batteries respectively having LiBOB concentrations in the non-aqueous electrolyte solution of 0.01 mol/kg, 0.015 mol/kg, 0.025 mol/kg, 0.05 mol/kg, and 0.1 mol/kg. As shown in Fig. 4, the ratio X of the coating having the three-coordinate structure increased as the concentration LiBOB decreased.

In the relationship between the LiBOB concentration and the battery characteristics shown in Fig. 1, a result was obtained in which the battery characteristics are improved when the LiBOB concentration in the non-aqueous electrolyte solution is less than 0.05 mol/kg. Accordingly, from the results shown in Figs. 1 and 4, it can be said that the battery characteristics of the lithium secondary batteries are improved when the ratio X of the coating having the three-coordinate structure is 0.4 or more. In order to set the ratio X of the coating having the three-coordinate structure to 0.4, the LiBOB concentration in the non-aqueous electrolyte solution is set to be less than 0.05 mol/kg, and more preferably, equal to or less than 0.4 mol/kg.

<Evaluation of lithium secondary battery by retention endurance test>

Next, a stricter retention endurance test was conducted on each lithium secondary battery prepared as described above, and the resistance increase ratio and capacity retention ratio thereof were measured. The retention endurance test was conducted in such a manner that the state of charge of the lithium secondary battery obtained after the conditioning process was adjusted to an SOC of 80% and the secondary battery was then left for six months in an environment of 60°C. The measurement of the capacity retention ratio was carried out by the method described above. The measurement of the resistance increase ratio was carried out by the following method.

Prior to the retention endurance test, the initial resistance value (internal resistance value) of each lithium secondary battery was measured. The measurement of the internal resistance value was carried out in such a manner that the state of each lithium secondary battery was adjusted to an SOC of 50% and currents of 0.12 A, 0.4 A, 1.2 A, 2.4 A, and 4.8 A were caused to flow through each lithium secondary battery to measure the battery voltage after a lapse of 10 seconds. The currents caused to flow through each lithium secondary battery and the voltages thereof were linearly approximated, and an internal resistance value (IV resistance value) was obtained from the slope of the straight line. After the retention endurance test, the internal resistance value (IV resistance value) was obtained in the same manner as in the case of measuring the initial resistance value. Further, assuming that the initial resistance value is represented by a resistance value R0 and the resistance value obtained after the retention endurance test is represented by a resistance value Ra, the resistance increase ratio was calculated using the following formula:

$$\text{resistance increase ratio (\%)} = \{(\text{resistance value Ra} - \text{resistance value R0})/\text{resistance value R0}\}\times 100$$

Fig. 5 shows relationships among the three-coordinate structure ratio, the resistance increase ratio, and the capacity retention ratio when the LiBOB concentration in the non-aqueous electrolyte solution is changed. As shown in Fig. 5, when the LiBOB concentration in the non-aqueous electrolyte solution was 0.01 mol/kg (Example 1), the three-coordinate structure ratio X was 0.7. In this case, the resistance increase ratio was 68% and the capacity retention ratio was 91%, so that excellent battery characteristics were obtained. When the LiBOB concentration in the non-aqueous electrolyte solution was 0.015 mol/kg (Example 2), the three-coordinate structure ratio X was 0.58. In this case, the resistance increase ratio was 70% and the capacity retention ratio was 92%, so that excellent battery characteristics were also obtained. When the LiBOB concentration in the non-aqueous electrolyte solution was 0.025 mol/kg (Example 3), the three-coordinate structure ratio X was 0.49. In this case, the resistance increase ratio was 70% and the capacity retention ratio was 90%, so that excellent battery characteristics were also obtained.

On the other hand, when the LiBOB concentration in the non-aqueous electrolyte solution was 0.05 mol/kg

(Example 4), the three-coordinate structure ratio X was 0.37. In this case, the resistance increase ratio was 90% and the capacity retention ratio was 77%, which indicates deterioration in battery characteristics. When the LiBOB concentration in the non-aqueous electrolyte solution was 0.1 mol/kg (Example 5), the three-coordinate structure ratio X was 0.36. In this case, the resistance increase ratio was 100% and the capacity retention ratio was 70%, which indicates further deterioration in battery characteristics. Thus, the effect of improving the battery characteristics is reduced when the LiBOB concentration in the non-aqueous electrolyte solution is increased, and thus it is surmised that the coating having the four-coordinate structure derived from LiBOB is not involved in the improvement of the battery characteristics.

Note that in Example 4 in which the LiBOB concentration in the non-aqueous electrolyte solution was 0.05 mol/kg, the capacity retention ratio was 77%, which is different from the result shown in Fig. 1. This is because the period of the retention endurance test in the case shown in Fig. 1 is one month, whereas the period of the retention endurance test in Example 4 is six months, which is longer than that of the case shown in Fig. 1.

The above results show that the battery characteristics of the lithium secondary batteries were improved by setting the ratio of the coating having the three-coordinate structure derived from LiBOB formed on the negative electrode surface to satisfy $X \geq 0.4$. In particular, the battery characteristics of the lithium secondary batteries were improved by setting the ratio of the coating having the three-coordinate structure to satisfy $X \geq 0.49$, preferably $X \geq 0.58$, and more preferably $X \geq 0.7$.

In order to set the ratio of the coating having the three-coordinate structure to satisfy $X \geq 0.49$, the LiBOB concentration in the non-aqueous electrolyte solution is set to 0.025 mol/kg or less. In order to set the ratio of the coating having the three-coordinate structure to satisfy $X \geq 0.58$, the LiBOB concentration in the non-aqueous electrolyte solution is set to 0.015 mol/kg or less. In order to set the ratio of the coating having the three-coordinate structure to satisfy $X \geq 0.7$, the LiBOB concentration in the non-aqueous electrolyte solution is set to 0.01 mol/kg or less.

<Conditions for conditioning process and battery characteristic 1>

Next, the following experiments were conducted to evaluate the relationship between the conditions for the conditioning process and the battery characteristics. In the experiments, the lithium secondary battery (with a LiBOB concentration in the non-aqueous electrolyte solution of 0.015 mol/kg) prepared as described above was used. As the conditions for the conditioning process, the operation of charging the lithium secondary battery at a constant current and a constant voltage to 4.1 V at a predetermined charge rate (0.1 C, 1.0 C, 5.0 C) and the operation of discharging the lithium secondary battery at a constant current and a constant voltage to 3.0 V at a predetermined discharge rate (0.1 C, 1.0 C, 5.0 C) were each repeated three times.

Fig. 6 shows relationships among the three-coordinate structure ratio, the resistance increase ratio, and the capacity retention ratio when the conditions (charge/discharge rate) for the conditioning process are changed. As shown in Fig. 6, when the charge/discharge rate was 0.1 C (Example 6), the three-coordinate structure ratio X was 0.79. In this case, the resistance increase ratio was 68% and the capacity retention ratio was 92%, so that excellent battery characteristics were obtained. In particular, when the three-coordinate structure ratio X was equal to or higher than 0.79, it is surmised that the uniformity of the coating derived from LiBOB within the plane of the negative electrode plate and in the cross-sectional direction thereof is improved, with the result that the battery characteristics are improved. When the charge/discharge rate was 1.0 C (Example 7), the three-coordinate structure ratio X was 0.63. In this case, the resistance increase ratio was 70% and the capacity retention ratio was 90%, so that excellent battery characteristics were obtained.

On the other hand, when the charge/discharge rate was 5.0 C (Example 8), the three-coordinate structure ratio X was 0.33. In this case, the resistance increase ratio was 110% and the capacity retention ratio was 67%, so that sufficient battery characteristics were not obtained. Note that as minimum battery characteristics of each lithium secondary battery, it is necessary to satisfy the condition in which the resistance increase ratio is smaller than 70% and the capacity retention ratio is larger than 72%.

The results shown in Fig. 6 indicate that the three-coordinate structure ratio X increases as the charge/discharge rate for use in the conditioning process decreases. This is assumed to be because the decomposition reaction of LiBOB on the negative electrode surface is promoted as the charge/discharge rate for use in the conditioning process decreases.

<Conditions for conditioning process and battery characteristic 2>

Furthermore, the following experiments were conducted to evaluate the relationship between the conditions for the conditioning process and the battery characteristics. In the experiments, the lithium secondary battery (with a LiBOB concentration in the non-aqueous electrolyte solution of 0.015 mol/kg) prepared as described above was used. As the conditions for the conditioning process, the operation of charging the lithium secondary battery at a constant current and a constant voltage to 4.1 V at a charge rate of 1.0 C and the operation of discharging the lithium secondary battery at a constant current and a constant voltage to 3.0 V at a discharge rate of 1.0 C were each repeated a predetermined number of times (once, three times, or ten times).

Fig. 7 shows relationships among the three-coordinate structure ratio, the resistance increase ratio, and the capacity retention ratio when the conditions (the number of cycles) for the conditioning process are changed. As shown in Fig. 7, when the number of cycles was one (Example 9), the three-coordinate structure ratio X was 0.30. In this case, the resistance increase ratio was 106% and the capacity retention ratio was 65%, so that sufficient battery characteristics were not obtained. When the number of cycles was three (Example 10), the three-coordinate structure ratio X was 0.61. In this case, the resistance increase ratio was 69% and the capacity retention ratio was 91%, so that excellent battery characteristics were obtained. Further, when the number of cycles was ten (Example 11), the three-coordinate structure ratio X was 0.35. In this case, the resistance increase ratio was 102% and the capacity retention ratio was 71%, so that sufficient battery characteristics were not obtained.

The results shown in Fig. 7 indicate that when the number of cycles of carrying out the conditioning process was small (once) or large (ten times), the three-coordinate structure ratio X was low and excellent battery characteristics were not obtained. When the number of cycles of carrying out the conditioning process was moderate (three times), the three-coordinate structure ratio X was large and excellent battery characteristics were obtained.

The above results show that the ratio X of the coating having the three-coordinate structure can be increased by setting the charge/discharge rate to a smaller value. Specifically, the ratio X of the coating having the three-coordinate structure can be increased by setting the charge/discharge rate for use in the conditioning process to be equal to or less than 1.0 C. In this case, if the charge/discharge rate is set to an extremely small value, it takes a long time to carry out the conditioning process. Accordingly, to carry out the conditioning process most efficiently, the charge/discharge rate is set to be equal to or more than 0.1 C and equal to or less than 1.0 C. To carry out the conditioning process most effectively, the number of cycles of the conditioning process is set to three.

The present invention has been described above with reference to the embodiments and examples described above. However, the present invention is not limited only to the configurations of the embodiments and examples described above, but includes various modifications, alterations, and combinations which can be made by those skilled in the art within the scope of the claims of the present application, as a matter of course.

## Claims

1. A method of evaluating a non-aqueous electrolyte secondary battery including a positive electrode, a negative electrode including a carbon material, and a non-aqueous electrolyte solution, the method comprising:

   measuring, by an XAFS method, an intensity $\alpha$ of a peak attributable to a three-coordinate structure of a coating derived from lithium bis(oxalate)borate formed on the negative electrode;
   measuring, by the XAFS method, an intensity $\beta$ of a peak attributable to a four-coordinate structure of the coating; and
   evaluating the non-aqueous electrolyte secondary battery based on whether or not the coating satisfies $\alpha/(\alpha+\beta) \geq 0.4$.

2. The method of evaluating the non-aqueous electrolyte secondary battery according to Claim 1, wherein the non-aqueous electrolyte secondary battery is evaluated based on whether or not the coating satisfies $\alpha/(\alpha+\beta) \geq 0.49$.

3. The method of evaluating the non-aqueous electrolyte secondary battery according to Claim 1, wherein the non-aqueous electrolyte secondary battery is evaluated based on whether or not the coating satisfies $\alpha/(\alpha+\beta) \geq 0.7$.

4. The method of evaluating the non-aqueous electrolyte secondary battery according to Claim 1, wherein the non-aqueous electrolyte secondary battery is evaluated based on whether or not the coating satisfies $\alpha/(\alpha+\beta) \geq 0.79$.

5. The method of evaluating the non-aqueous electrolyte secondary battery according to any one of Claims 1 to 4, wherein in the measurement by the XAFS method, the three-coordinate structure of the coating is detected by using a peak of X-ray energy in the vicinity of 194 eV, and the four-coordinate structure of the coating is detected by using a peak of X-ray energy in the vicinity of 198 eV.

## Patentansprüche

1. Verfahren zur Evaluierung einer nichtwässrigen Elektrolytsekundärbatterie, die eine Positivelektrode, eine ein Kohlenstoffmaterial beinhaltende Negativelektrode und eine nichtwässrige Elektrolytlösung beinhaltet, wobei das Verfahren umfasst:

Messen durch ein XAFS-Verfahren einer Intensität α eines Peaks, der einer dreifach-koordinierten Struktur einer Beschichtung zuzuordnen ist, die aus Lithiumbis(oxalat)borat abstammt, die auf der Negativelektrode gebildet ist;
Messen durch das XAFS-Verfahren einer Intensität β eines Peaks, der einer vierfach-koordinierten Struktur der Beschichtung zuzuordnen ist; und
Evaluieren der nichtwässrigen Elektrolytsekundärbatterie basierend darauf, ob die Beschichtung $\alpha/(\alpha+\beta) \geq 0{,}4$ erfüllt oder nicht.

**2.** Verfahren zur Evaluierung der nichtwässrigen Elektrolytsekundärbatterie nach Anspruch 1, wobei die nichtwässrige Elektrolytsekundärbatterie basierend darauf evaluiert wird, ob die Beschichtung $\alpha/(\alpha+\beta) \geq 0{,}49$ erfüllt oder nicht.

**3.** Verfahren zur Evaluierung der nichtwässrigen Elektrolytsekundärbatterie nach Anspruch 1, wobei die nichtwässrige Elektrolytsekundärbatterie basierend darauf evaluiert wird, ob die Beschichtung $\alpha/(\alpha+\beta) \geq 0{,}7$ erfüllt oder nicht.

**4.** Verfahren zur Evaluierung der nichtwässrigen Elektrolytsekundärbatterie nach Anspruch 1, wobei die nichtwässrige Elektrolytsekundärbatterie basierend darauf evaluiert wird, ob die Beschichtung $\alpha/(\alpha+\beta) \geq 0{,}79$ erfüllt oder nicht.

**5.** Verfahren zur Evaluierung der nichtwässrigen Elektrolytsekundärbatterie nach einem der Ansprüche 1 bis 4, wobei in der Messung durch das XAFS-Verfahren die dreifach-koordinierte Struktur der Beschichtung durch Verwenden eines Röntgenstrahlenergiepeaks in der Nähe von 194 eV detektiert wird, und die vierfach-koordinierte Struktur der Beschichtung durch Verwenden eines Röntgenstrahlenergiepeaks in der Nähe von 198 eV detektiert wird.

## Revendications

**1.** Procédé d'évaluation d'une batterie secondaire à électrolyte non aqueux, comprenant une électrode positive, une électrode négative renfermant un matériau carboné, et une solution d'électrolyte non aqueux, ledit procédé comprenant :

la mesure, par une méthode XAFS, d'une intensité α d'un pic pouvant être attribué à une structure à trois coordonnées d'un revêtement dérivé du bis(oxalate)borate de lithium formé sur l'électrode négative ;
la mesure, par une méthode XAFS, d'une intensité β d'un pic pouvant être attribué à une structure à quatre coordonnées du revêtement ; et
l'évaluation de la batterie secondaire à électrolyte non aqueux sur la base de la condition satisfaite ou non satisfaite par le revêtement $\alpha/(\alpha+\beta) \geq 0{,}4$.

**2.** Procédé d'évaluation de la batterie secondaire à électrolyte non aqueux selon la revendication 1, dans lequel la batterie secondaire à électrolyte non aqueux est évaluée sur la base de la condition satisfaite ou non satisfaite par le revêtement $\alpha/(\alpha+\beta) \geq 0{,}49$.

**3.** Procédé d'évaluation de la batterie secondaire à électrolyte non aqueux selon la revendication 1, dans lequel la batterie secondaire à électrolyte non aqueux est évaluée sur la base de la condition satisfaite ou non satisfaite par le revêtement $\alpha/(\alpha+\beta) \geq 0{,}7$.

**4.** Procédé d'évaluation de la batterie secondaire à électrolyte non aqueux selon la revendication 1, dans lequel la batterie secondaire à électrolyte non aqueux est évaluée sur la base de la condition satisfaite ou non satisfaite par le revêtement $\alpha/(\alpha+\beta) \geq 0{,}79$.

**5.** Procédé d'évaluation de la batterie secondaire à électrolyte non aqueux selon l'une quelconque des revendications 1 à 4, dans lequel, dans la mesure par la méthode XAFS, la structure à trois coordonnées du revêtement est détectée en utilisant un pic d'énergie de rayons X au voisinage de 194 eV, et la structure à quatre coordonnées du revêtement est détectée en utilisant un pic d'énergie de rayons X au voisinage de 198 eV.

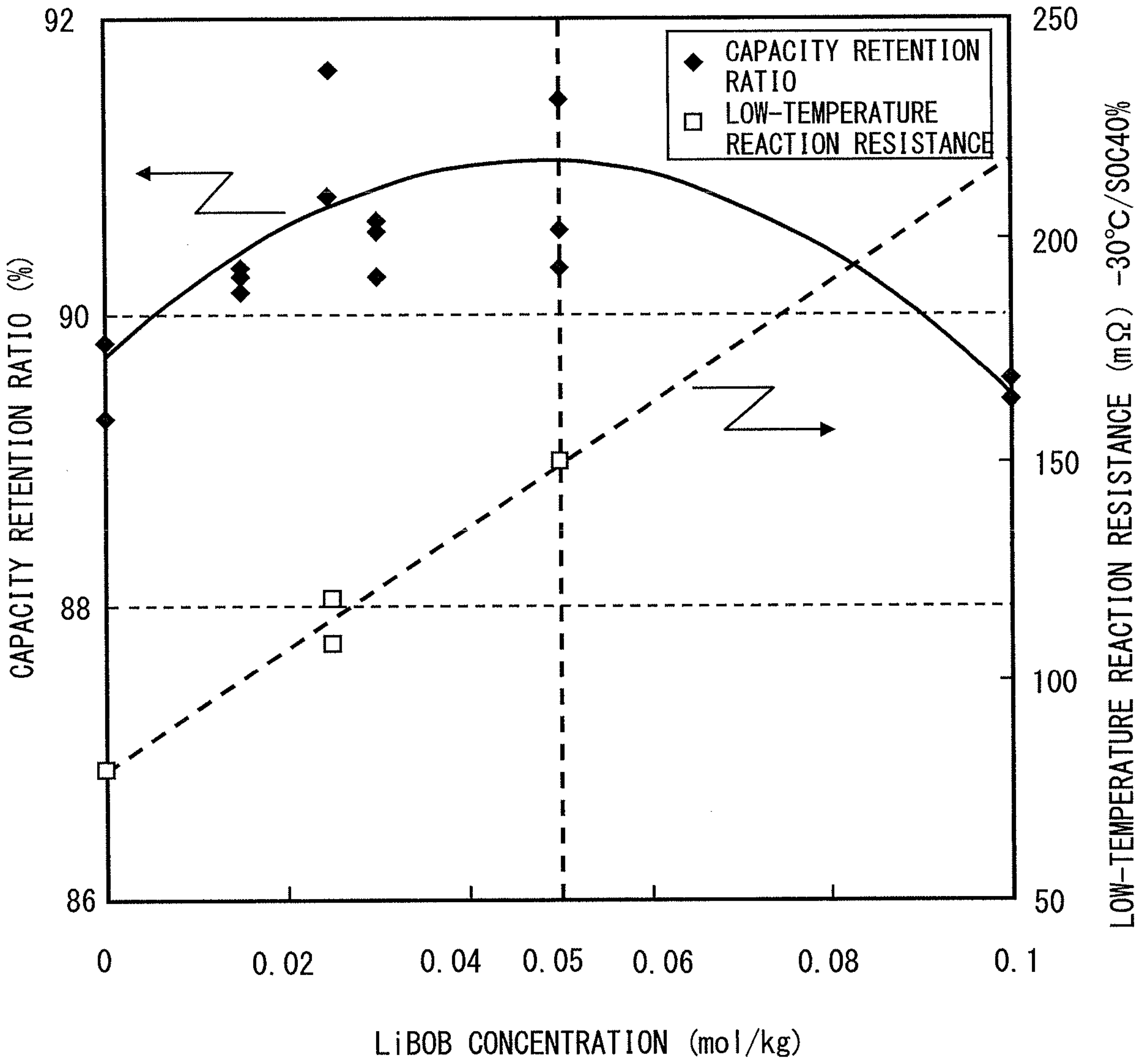
92
90
88
86
250
200
150
100
50
CAPACITY RETENTION RATIO
LOW-TEMPERATURE REACTION RESISTANCE
CAPACITY RETENTION RATIO (%)
LOW-TEMPERATURE REACTION RESISTANCE (mΩ) -30°C/SOC40%
0
0.02
0.04
0.05
0.06
0.08
0.1
LiBOB CONCENTRATION (mol/kg)

Fig. 1

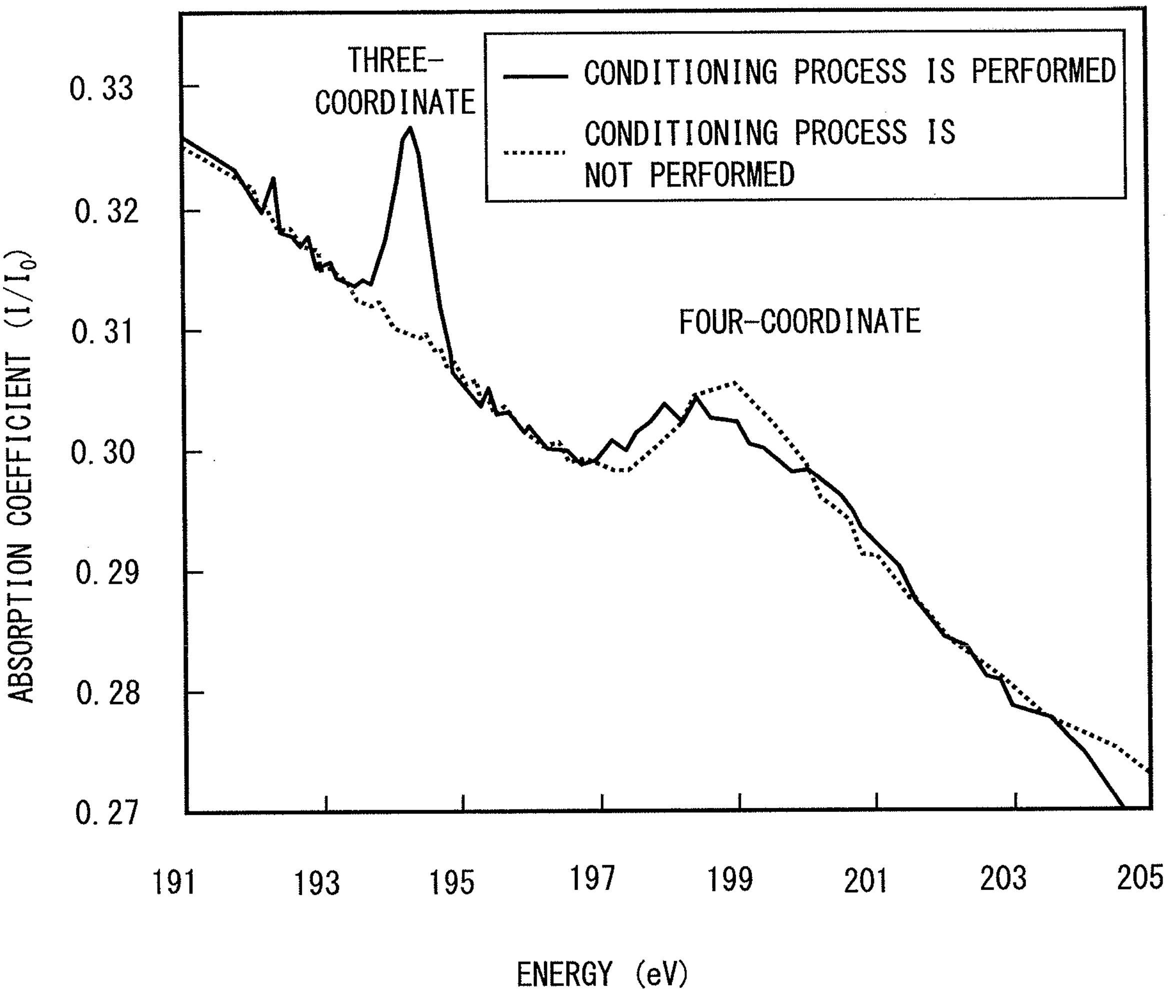
THREE-
COORDINATE
FOUR-COORDINATE
CONDITIONING PROCESS IS PERFORMED
CONDITIONING PROCESS IS
NOT PERFORMED
0.33
0.32
0.31
0.30
0.29
0.28
0.27
ABSORPTION COEFFICIENT (I/I0)
191
193
195
197
199
201
203
205
ENERGY (eV)

Fig. 2

Fig. 3

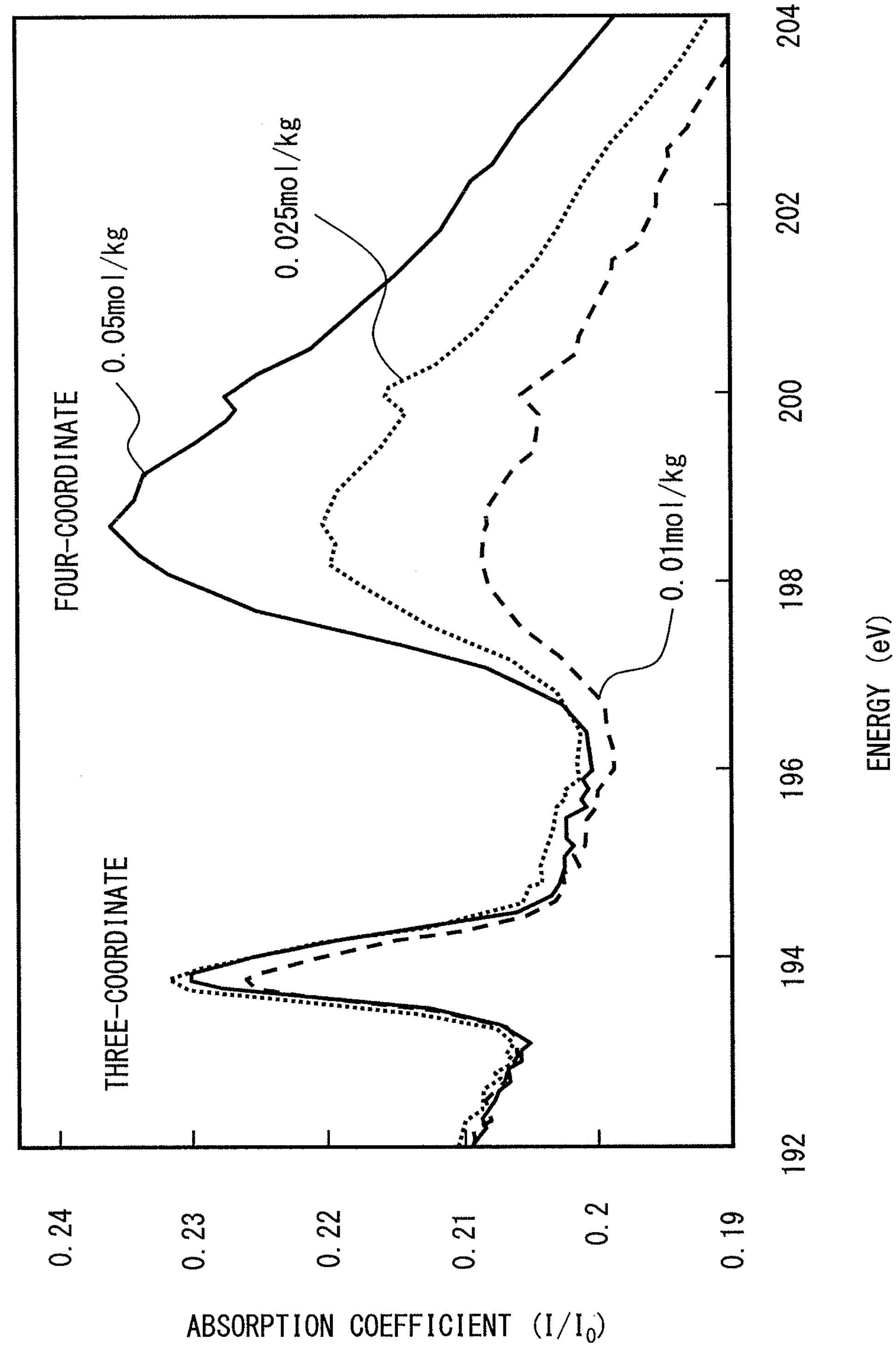
FOUR-COORDINATE
THREE-COORDINATE
0. 05mol/kg
0. 025mol/kg
0. 01mol/kg
0. 24
0. 23
0. 22
0. 21
0. 2
0. 19
192
194
196
198
200
202
204
ENERGY (eV)
ABSORPTION COEFFICIENT (I/I0)

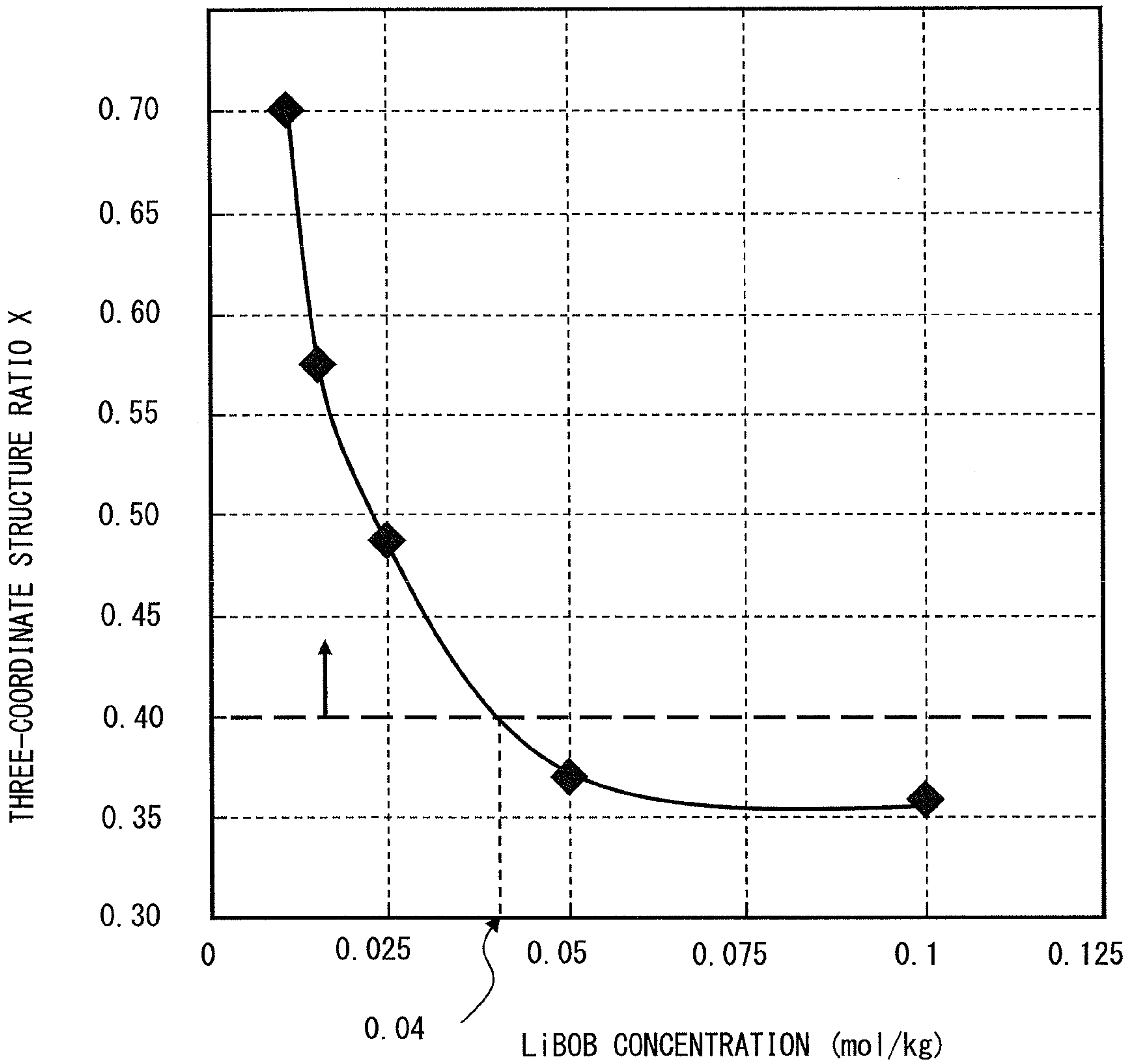
THREE-COORDINATE STRUCTURE RATIO X
0.70
0.65
0.60
0.55
0.50
0.45
0.40
0.35
0.30
0
0.025
0.05
0.075
0.1
0.125
0.04
LiBOB CONCENTRATION (mol/kg)

Fig. 4

| | LiBOB CONCENTRATION (mol/kg) | THREE-COORDINATE STRUCTURE RATIO X | THREE-COORDINATE INTENSITY | FOUR-COORDINATE INTENSITY | RESISTANCE INCREASE RATIO (%) | CAPACITY RETENTION RATIO (%) |
|---|---|---|---|---|---|---|
| EXAMPLE 1 | 0.01 | 0.70 | 4.8 | 2.1 | 68 | 91 |
| EXAMPLE 2 | 0.015 | 0.58 | 4.6 | 3.4 | 70 | 92 |
| EXAMPLE 3 | 0.025 | 0.49 | 4 | 4.2 | 70 | 90 |
| EXAMPLE 4 | 0.05 | 0.37 | 1 | 1.7 | 90 | 77 |
| EXAMPLE 5 | 0.1 | 0.36 | 1.4 | 2.5 | 100 | 70 |

Fig. 5

| | CHARGE/DISCHARGE RATE (C) | THREE-COORDINATE STRUCTURE RATIO X | THREE-COORDINATE INTENSITY | FOUR-COORDINATE INTENSITY | RESISTANCE INCREASE RATIO (%) | CAPACITY RETENTION RATIO (%) |
|---|---|---|---|---|---|---|
| EXAMPLE 6 | 0.1 | 0.79 | 4.8 | 1.3 | 68 | 92 |
| EXAMPLE 7 | 1.0 | 0.63 | 4 | 2.4 | 70 | 90 |
| EXAMPLE 8 | 5.0 | 0.33 | 1.2 | 2.4 | 110 | 67 |

Fig. 6

| | NUMBER OF CYCLES (NUMBER OF TIMES) | THREE-COORDINATE STRUCTURE RATIO X | THREE-COORDINATE INTENSITY | FOUR-COORDINATE INTENSITY | RESISTANCE INCREASE RATIO (%) | CAPACITY RETENTION RATIO (%) |
|---|---|---|---|---|---|---|
| EXAMPLE 9 | 1 | 0. 30 | 0. 3 | 0. 7 | 106 | 65 |
| EXAMPLE 10 | 3 | 0. 61 | 3. 4 | 2. 2 | 69 | 91 |
| EXAMPLE 11 | 10 | 0. 35 | 0. 6 | 1. 1 | 102 | 71 |

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2011104564 A1
- JP 2011034893 A


### Non-patent literature cited in the description


- **XU K. et al.** Graphite/Electrolyte Interface Formed in LiBOB-Based Electrolytes. *Journal of the Electrochemical Society,* 01 January 2004, vol. 151 (12), ISSN 0013-4651, A2106-A2112
- XAFS and TOF-SIMS analysis of SEI layers on electrodes. **OTA H. et al.** Journal of Power Sources. Elsevier Sa, 01 June 2003, vol. 119-121, 567-571